# EUROPÄISCHE PATENTSCHRIFT

(11) **EP 0 605 438 B1**
(45) Veröffentlichungstag und Bekanntmachung des Hinweises auf die Patenterteilung: **02.10.1996**
(21) Anmeldenummer: 92916258.4
(22) Anmeldetag: 30.07.1992
(51) Int. Cl.: H02J 7/00, G01R 31/36

(54) **BATTERIEBETRIEBENES GERÄT**
BATTERY-OPERATED DEVICE
APPAREIL A PILE

(30) Priorität: 26.09.1991 DE 4131981
(43) Veröffentlichungstag der Anmeldung: 13.07.1994
(60) Teilanmeldung: 95119896.9
(73) Patentinhaber: Braun Aktiengesellschaft, 60326 Frankfurt am Main (DE)
(72) Erfinder: LANG, Gerhard, D-61276 Altweilnau (DE); WOLF, Jürgen, D-65830 Kriftel (DE)
(86) Internationale Anmeldenummer: DE9200639
(87) Internationale Veröffentlichungsnummer: WO9306643

(56) Entgegenhaltungen:
- EP-A- 0 240 883
- US-A- 4 380 726
- US-A- 4 703 247
- US-A- 4 835 453

## Beschreibung

Die Erfindung betrifft ein elektrisches Gerät mit einer Batterie, einem von der Batterie über einen elektronischen Schalter gespeisten elektrischen Verbraucher, bei dem die Batterie bei Erreichen des Entladezustandes der Batterie von dem Verbraucher getrennt wird, indem die Energiezufuhr zu dem Verbraucher mit der Zeit reduziert wird.

Es ist bereits ein derartiges Gerät bekannt (EP 0 240 883 A2), bei dem die Leistungszufuhr beispielsweise zu einer Lampe reduziert wird, wenn die Batteriespannung einen bestimmten Schwellwert erreicht hat. Dabei erfolgt die Reduzierung der Leistungszufuhr bevorzugt so, daß nach Erreichen des bestimmten Schwellwertes bei weiter absinkender Batteriespannung die Leistungszufuhr mit absinkender Batteriespannung reduziert wird. Bei Erreichen eines weiteren Schwellwertes der Batteriespannung wird die Versorgungsspannung vollständig abgetrennt. Die Reduzierung der Leistungsaufnahme erfolgt dabei, indem die an den Verbraucher angelegte Versorgungsspannung getaktet wird. Die Reduzierung der Leistungsaufnahme erfolgt dabei in dem gesamten Zeitverhalten so, daß der Benutzer das Erreichen des Entladezustandes rechtzeitig erkennt durch die absinkende Leistungsaufnahme des Gerätes bereits einige Zeit vor Erreichen des weiteren Schwellwertes.

Batteriebetriebene elektrische Geräte, insbesondere Geräte des Konsumgüterbereichs, wie aufladbare Rasierapparate, werden in zunehmendem Maße mit Displays versehen, die den aktuellen Ladezustand der Batterie oder des Akkumulators anzeigen. Solche Ladezustandsanzeigen erfolgen aus Kostengründen meist auf Zeitbasis, da solche Geräte einen im wesentlichen konstanten Stromverbrauch (konstante Leistung) haben und die Nennkapazität der Batterie bekannt ist.

Auf Grund von Kapazitätsänderungen der Batterie und/oder Schwankungen im Stromverbrauch des Geräts kann es dabei zu Fehlanzeigen des Displays über den wirklichen Ladezustand der Batterie kommen. Dies ist insbesondere gegen Ende eines Entladezyklus, wenn die Batterie fast leer ist, störend.

Es ist weiterhin bekannt (US-PS 4,380,726) in einem Batterie-betriebenen Gerät die Batteriespannung zu erfassen und in einem Datenspeicher wenigstens einem Wert der Batteriespannung eine Restbetriebszeit der Batterie zuzuordnen. Wenn die erfaßte Batteriespannung mit dem entsprechenden Wert der Batteriespannung übereinstimmt, wird die zugeordnete Restbetriebszeit auf einem Display angezeigt. Weiterhin ist es aus dieser Schrift bekannt, entsprechend der fortdauernden Entladung der Batterie eine Restbetriebszeit zu ermitteln und auf einem Display anzuzeigen.

Aufgabe der Erfindung ist es, die Genauigkeit der Ladezustandsanzeige eines batteriebetriebenen elektrischen Geräts gegen Ende des Entladezyklus zu verbessern und die Batterie vor Tiefentladungen zu schützen.

Die Lösung der Aufgabe bei einem Gerät der eingangs genannten Art mit einem Zeitglied, das die Anschlußzeit des Verbrauchers an die Batterie feststellt, erfolgt nach den kennzeichnenden Merkmalen des Anspruches 1.

Die Lösung der Aufgabe bei einem Gerät der eingangs genannten Art mit einem Spannungsdiskriminator, der eine vorgegebene Spannung an der Batterie detektiert, erfolgt nach den kennzeichnenden Merkmalen des Anspruches 2.

Dabei wird die Motordrehzahl des Gleichstrommotors stufenweise oder kontinuierlich bis auf Null reduziert, um so zu verhindern, daß der Motor schlagartig stehen bleibt, was beispielsweise bei einem elektrischen Rasierapparat oder einer Haarschneidemaschine störend wäre, weil Haare eingeklemmt werden können. Diese reduzierung erfolgt dabei dann, wenn auf dem Display der Ladezustand "Null" angezeigt wird. Bis zu dahin wird der Motor mit der maximal zur Verfügung stehenden Leistung versorgt.

Eine vorteilhafte Ausgestaltung der Erfindung nach Anspruch 3 besteht darin, daß das Zeitglied nach Ablauf der vorgegebenen Zeit einen Pulsbreitenmodulator ansteuert, der das Tastverhältnis der Steuerspannung für den elektronischen Schalter reduziert.

Weitere vorteilhafte Ausgestaltungen sind den übrigen Unteransprüchen und der Beschreibung entnehmbar.

Die Erfindung wird im folgenden an Hand von in der Zeichnung dargestellten Ausführungbeispielen näher beschrieben.

Es zeigen:
- Fig. 1: ein Blockschaltbild,
- Fig. 2: ein Ausführungsbeispiel mit einem Motor als elektrischen Verbraucher,
- Fig. 3: ein Ausgangssignal des Pulsbreitenmodulators in Fig. 2, wenn die Drehzahl des Motors entsprechend einer fallenden Batteriespannung verringert wird,
- Fig. 4: die Motordrehzahl bei Steuerung des Tastverhältnisses des Pulsbreitenmodulators entsprechend Fig. 3.

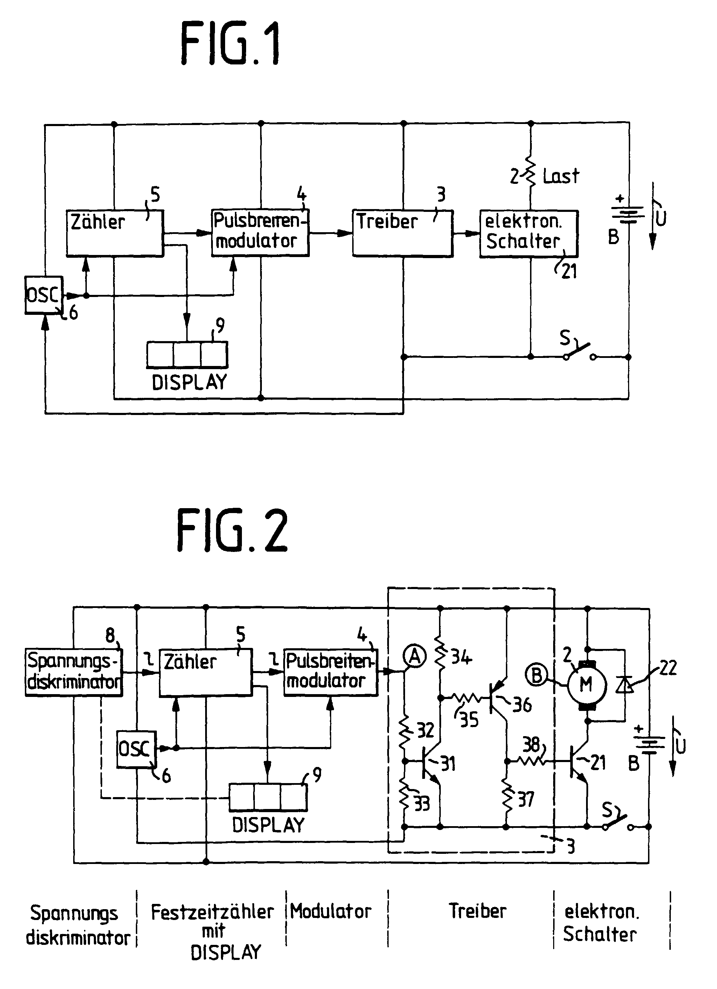

In Fig. 1 wird über einen Ein-/Ausschalter S und über einen elektronischen Schalter 21 die Last (der Verbraucher) 2 an die Batterie (Akkumulator) B geschaltet. Die Batterie B kann über eine nicht dargestellte Ladeschaltung aufgeladen werden. Der elektronische Schalter 21 wird über eine Treiberschaltung 3 von einem Pulsbreitenmodulator 4 angesteuert.

Der Zähler 5 registriert die Anschlußzeit der einen im wesentlichen konstanten Stromverbrauch aufweisenden Last L über den Schalter S an die Batterie B ab vollgeladener Batterie.

Da auch die Nennkapazität der Batterie B bekannt ist, wird das den Ladezustand der Batterie anzeigende Display 9 auf Zeitbasis vom Zähler 5 gesteuert. Wenn eine vorgegebene Anschlußzeit vergangen ist, die auf Grund des bekannten Stromverbrauchs und der bekannten Nennkapazität der Batterie B derart bestimmt wird, daß die Batterie dann nur noch wenig Ladung enthält, gibt der Zähler 5 ein Ausgangssignal ab. Zu diesem Zeitpunkt zeigt das Display 9 den Ladezustand "Null" an. Dieses Signal bewirkt, daß der elektronische Schalter 21 angesteuert wird. Diese Ansteuerung kann über einen Pulsbreitenmodulator 4 erfolgen, der das Tastverhältnis der Steuerspannung allmählich bis auf Null reduziert und so den durch die Last 2 fließenden Strom allmählich verkleinert. Der Oszillator 6 stellt die Taktimpulse für den Zähler 5 und den Pulsbreitenmodulator 4 bereit.

In Fig. 2 ist der Verbraucher (die Last) 2 ein Gleichstrommotor M, beispielsweise eines elektrischen Rasierapparates. Die Serienschaltung des Motors M mit dem Schalttransistor 21 wird über den Ein-/Ausschalter S bei Inbetriebnahme an die Batterie B gelegt. Die zum Motor M parallel geschaltete Diode 22 verhindert induktive Spannungsspitzen. Die Basis des Schalttransistors 21 wird über eine aus den Transistoren 31, 36 und den Widerständen 32, 33, 34, 35, 37, 38 bestehende Treiberschaltung 3 vom Ausgang des Pulsbreitenmodulators 4 angesteuert.

Der Batterie B ist ein Spannungsdiskriminator 8 und der Zähler 5 direkt parallel geschaltet, das heißt nicht über den Ein-/Ausschalter S. Der Spannungsdiskriminator 8 detektiert eine bestimmte Spannung U an der Batterie B. Diese detektierte Spannung U ist beispielsweise der sogenannte "low charge" Punkt, das ist eine an der Batterie anstehende Spannung U, wenn die Batterie nur noch 10 bis 20% ihrer Ladung enthält. Bis zum Erreichen dieses low charge Punktes zeigt das Display 9 den auf Grund der vergangenen Anschlußzeit des Motors M an die Batterie B den Ladezustand an.

Hat der Spannungsdiskriminator 8 den low charge Punkt der Spannung U an der Batterie B detektiert, wird der Zähler 5 und eine zweite Anzeigeeinheit des Displays 9 gestartet. Wenn der detektierte low charge Punkt erreicht ist, kann der Motor beispielsweise nur noch 8 Minuten bis zur vollständigen Entladung der Batterie B betrieben werden. Die für den Zähler 5 vorgegebene Zeit beträgt nun beispielsweise 6 Minuten, um eine vollständige Entladung der Batterie mit Sicherheit zu verhindern. Diese 6 Minuten können in sechs feste, gleichgroße Zeitintervalle unterteilt werden, so daß jede Minute ein Segment der zweiten Anzeigeeinheit des Displays 9 angesteuert wird. Diese Segmente können auch die noch verbleibenden Minuten bis zum Ablauf der vorgegebenen Zeit anzeigen. Nach Ablauf der vorgegebenen Zeit (6 Minuten), das heißt wenn der Zähler 5 auf Null angelangt ist, wird der Pulsbreitenmodulator 4 angesteuert.

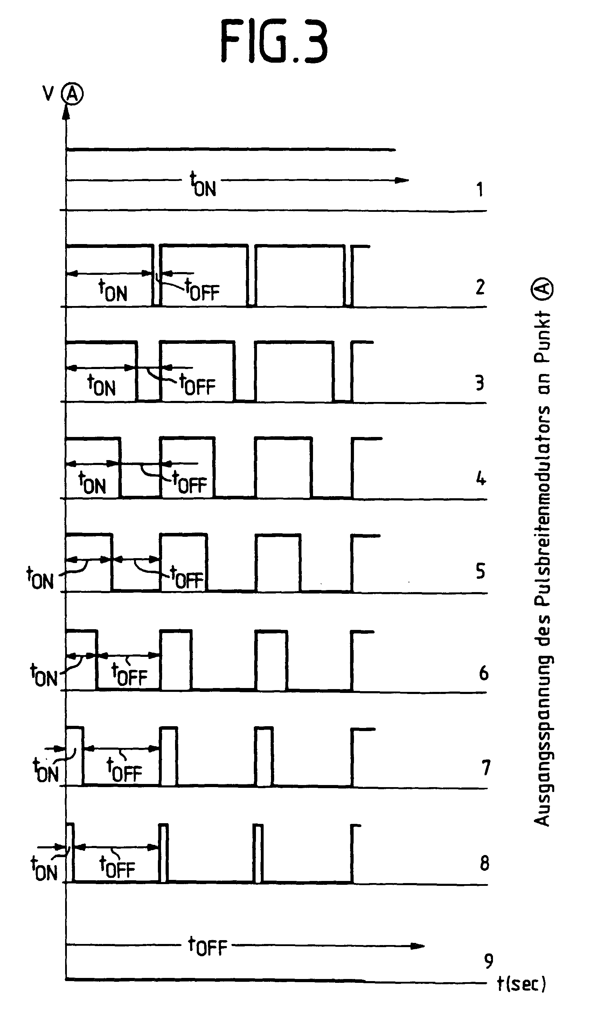

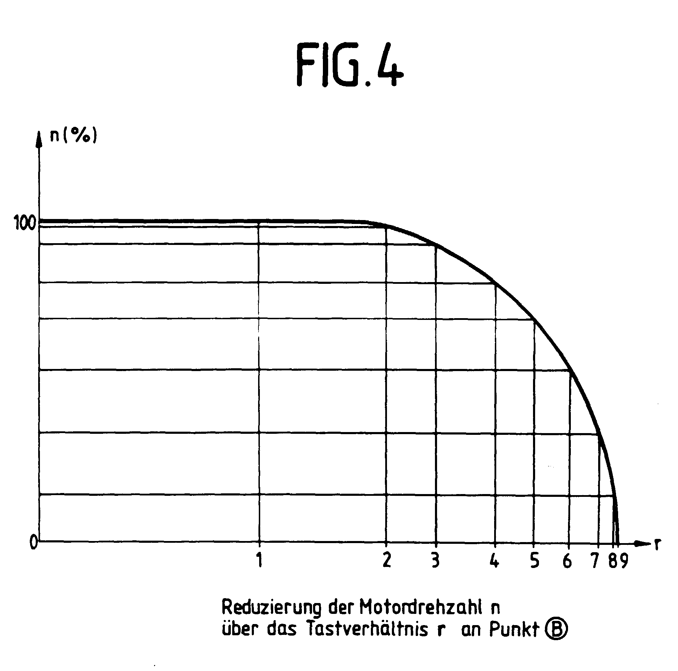

Dieser Pulsbreitenmodulator 4 reduziert das Tastverhältnis der dem Treiber 3 zugeführten Steuerspannung auf eine beispielsweise in Fig. 3 dargestellte Weise. Die verschiedenen Tastverhältnisse in Fig. 3 sind mit Ziffern von 1 (volle Steuerspannung) bis 9 (Steuerspannung Null) versehen. In Fig. 4 ist nun die Motordrehzahl (in % der Nenndrehzahl) in Abhängigkeit dieser Tastverhältnisse dargestellt, wobei die mit den Ziffern 1 bis 9 angegebenen Tastverhältnisse denen in Fig. 3 entsprechen. Diese Kurve entspricht im wesentlichen dem Verlauf der Spannung einer Batterie bei angeschaltetem Verbraucher bis zur vollständigen Entladung.

Auf diese Weise wird eine Tiefentladung der Batterie verhindert. Infolge des nicht abrupten Stillstands des Motors wird verhindert, daß bei einem Rasierapparat oder einer Haarschneidemaschine unvorhergesehen Haare schmerzhaft eingeklemmt werden.

## Patentansprüche

1. Elektrisches Gerät mit einer Batterie (B), einem von der Batterie über einen elektronischen Schalter (21) gespeisten elektrischen Verbraucher (2), dessen Leistungszufuhr bei einer bestimmten Entladung der Batterie reduziert wird bis die zugeführte Leistung gleich null beträgt,
**dadurch gekennzeichnet,**
daß das elektrische Gerät ein elektrischer Rasierapparat oder eine Haarschneidemaschine ist,
daß der elektrische Verbraucher ein Gleichstrommotor (M) ist mit im wesentlichen konstantem Stromverbrauch,
daß ein Display (9) zur Anzeige des Ladezustandes der Batterie (B) und ein Zeitglied, das die Anschlußzeit des Verbrauchers (2) an die Batterie (B) feststellt, vorhanden sind,
daß nach Ablauf einer bestimmten Anschlußzeit des Gleichstrommotors (M) an die Batterie (B), wenn das Display (9) den Ladezustand "Null" anzeigt, das Zeitglied (5) den Gleichstrommotor (M) mittels des elektronischen Schalters (21) von der Batterie (B) trennt, indem die Motordrehzahl derart stufenweise oder kontinuierlich bis auf Null reduziert wird, daß keine Haare eingeklemmt werden können.

2. Elektrisches Gerät mit einer Batterie (B), einem von der Batterie über einen elektronischen Schalter (21) gespeisten elektrischen Verbraucher (2), dessen Leistungszufuhr bei einer bestimmten Entladung der Batterie reduziert wird bis die zugeführte Leistung gleich null beträgt, und einem Spannungsdiskriminator (8), der eine vorgegebene Spannung (U) an der Batterie (B) detektiert,
**dadurch gekennzeichnet,**
daß das elektrische Gerät ein elektrischer Rasierapparat oder eine Haarschneidemaschine ist,
daß der elektrische Verbraucher ein Gleichstrommotor (M) ist,
daß ein Display (9) zur Anzeige des Ladezustandes der Batterie (B) vorhanden ist, daß bei Erreichen der vorgegebenen Spannung (U) an der Batterie (B) der Spannungsdiskriminator (8) ein Zeitglied (5) startet, welches das Display (9) steuert und nach Ablauf einer vorgegebenen Zeit, wenn das Display (9) den Ladezustand "Null" anzeigt, den Gleichstrommotor (M) mittels des elektronischen Schalters (21) von der Batterie (B) trennt, indem die Motordrehzahl derart stufenweise oder kontinuierlich bis auf Null reduziert wird, daß keine Haare eingeklemmt werden können.

3. Elektrisches Gerät nach Anspruch 1 oder 2,
**dadurch gekennzeichnet,**
daß das Zeitglied (5) nach Ablauf der vorgegebenen Zeit einen Pulsbreitenmodulator (4) ansteuert, der das Tastverhältnis der Steuerspannung für den elektronischen Schalter (21) reduziert, so daß die Motordrehzahl stufenweise oder kontinuierlich bis auf Null reduziert wird.

4. Elektrisches Gerät nach Anspruch 3,
**dadurch gekennzeichnet,**
daß die Reduzierung der Motordrehzahl linear mit der Zeit erfolgt.

5. Elektrisches Gerät nach Anspruch 3,
**dadurch gekennzeichnet,**
daß die Reduzierung der Motordrehzahl ähnlich dem Kurvenverlauf einer fallenden Batteriespannung kurz vor der vollständigen Entladung erfolgt.

6. Elektrisches Gerät nach Anspruch 1 oder 2,
**dadurch gekennzeichnet,**
daß das Zeitglied (5) ein von einem Oszillator (6) getakteter Festzeitzähler ist.

7. Elektrisches Gerät nach Anspruch 6,
**dadurch gekennzeichnet,**
daß die Einheiten Festzeitzähler (5), Oszillator (6) und Pulsbreitenmodulator (4) Bestandteile eines Mikroprozessors sind.

8. Elektrisches Gerät nach Anspruch 6,
**dadurch gekennzeichnet,**
daß der Festzeitzähler (5) in feste Zeitintervalle eingeteilt ist, die von dem Display (9) angezeigt werden.

9. Elektrisches Gerät nach Anspruch 2,
**dadurch gekennzeichnet,**
daß beim Start des Zeitglieds (5) das Display (9) bei Nichtübereinstimmung des angezeigten Ladezustands mit dem detektierten Ladezustand der Batterie (B) korrigiert wird und/oder eine weitere Anzeige des Displays (9) gestartet wird.

10. Elektrisches Gerät nach Anspruch 9,
**dadurch gekennzeichnet,**
daß die weitere Anzeige des Displays (9) die noch verbleibenden Minuten bis zum Ablauf der vorgegebenen Zeit anzeigt.

11. Elektrisches Gerät nach Anspruch 2,
**dadurch gekennzeichnet,**
daß der Spannungsdiskriminator (8) und das Zeitglied (5) der Batterie direkt parallel geschaltet sind und daß die Serienschaltung des elektrischen Verbrauchers (2) mit dem elektronischen Schalter (21) über einen Ein-/Ausschalter (S) an die Batterie (B) anschließbar ist.

## Claims

1. An electrical device with a battery (B) and an electrical load (2) powered by the battery via an electronic switching device (21), in which, when the battery has reached a specified discharge status, the supply of power to the load is reduced until the supplied power is equal to zero,
**characterized in that** the electrical device is an electric shaver or a hair clipper,
that the electrical load is a direct-current motor (M) having an essentially constant power consumption,
that there are provided a display means (9) for indicating the charge status of the battery (B), and a time measurement means determining the connection time of the load (2) to the battery (B),
that, following expiration of a set connection time of the direct-current motor (M) to the battery (B), when the display means (9) indicates the charge status "zero", the time measurement means (5) disconnects the direct-current motor (M) from the battery (B) by means of the electronic switching device (21), to the effect that the rotational frequency of the motor is reduced in steps or continually down to zero such as to eliminate the risk of hair being snagged.

2. The electrical device with a battery (B), an electrical load (2) powered by the battery via an electronic switching device (21), in which, when the battery has reached a specified discharge status, the supply of power to the load is reduced until the supplied power is equal to zero, and with a voltage discriminator (8) detecting a predetermined voltage (U) on the battery (B),
**characterized in that** the electrical device is an electric shaver or a hair clipper,
that the electrical load is a direct-current motor (M),
that a display means (9) is provided for indicating the charge status of the battery (B),
that, when the predetermined voltage (U) on the battery (B) is reached, the voltage discriminator (8) activates a time measurement means (5) that controls the display means (9) and disconnects the direct-current motor (M) from the battery (B) by means of the electronic switching device (21) following expiration of a predetermined time period, when the display means (9) indicates the charge status "zero", to the effect that the rotational frequency of the motor is reduced in steps or continually down to zero such as to eliminate the risk of hair being snagged.

3. The electrical device as claimed in claim 1 or claim 2,
**characterized in that** the time measurement means (5), following expiration of the predetermined time period, drives a pulse-duration modulator (4) reducing the pulse duty factor of the control voltage for the electronic switching device (21), so that the rotational frequency of the motor is reduced in steps or continually down to zero.

4. The electrical device as claimed in claim 3,
**characterized in that** the rotational frequency of the motor is reduced linearly with time.

5. The electrical device as claimed in claim 3,
**characterized in that** the rotational frequency of the motor is reduced similarly to the curve of a falling battery voltage shortly before complete depletion.

6. The electrical device as claimed in claim 1 or claim 2,
**characterized in that** the time measurement means (5) is a fixed-time counter pulsed by an oscillator (6).

7. The electrical device as claimed in claim 6,
**characterized in that** the units including the fixed-time counter (5), the oscillator (6), and the pulse-duration modulator (4) are components of a microprocessor.

8. The electrical device as claimed in claim 6,
**characterized in that** the fixed-time counter (5) is subdivided into fixed time intervals indicated by the display means (9).

9. The electrical device as claimed in claim 2,
**characterized in that** on activation of the time measurement means (5) the display means (9) is corrected in the event of non-agreement of the indicated charge status with the detected charge status of the battery (B), and/or a further indicating unit of the display means (9) is started.

10. The electrical device as claimed in claim 9,
**characterized in that** the further indicating unit of the display means (9) shows the minutes remaining until expiration of the predetermined time period.

11. The electrical device as claimed in claim 2,
**characterized in that** the voltage discriminator (8) and the time measurement means (5) are connected directly in parallel with the battery, and that the series arrangement comprising the electrical load (2) and the electronic switching device (21) is adapted to be connected to the battery (B) by means of an on/off switch (S).

## Revendications

1. Appareil électrique comprenant une batterie (B), un élément consommateur (2) électrique, alimenté par la batterie, par l'intermédiaire d'un interrupteur (21) électronique, l'amenée de puissance à cet élément consommateur (2), lors d'une décharge déterminée de la batterie, devenant réduite jusqu'à ce que la puissance amenée devienne égale à zéro,
caractérisé en ce,
que l'appareil électrique est un rasoir ou une tondeuse à cheveux électriques,
que l'élément consommateur électrique est un moteur à courant continu (M) avec, pour l'essentiel, une consommation de courant constante,
qu'un dispositif d'affichage (9), pour l'indication de l'état de charge de la batterie (B), et un élément temporisateur, qui fixe le temps de raccordement de l'élément consommateur (2) à la batterie (B), sont présents,
qu'après écoulement d'un temps de raccordement déterminé du moteur à courant continu (M) à la batterie (B), lorsque le dispositif d'affichage (9) indique l'état de charge "zéro", l'élément temporisateur (5) sépare le moteur à courant continu (M), au moyen de l'interrupteur (21) électronique, de la batterie (B), attendu que la vitesse de rotation du moteur sera réduite, pas-à-pas ou de façon continue, jusqu'à zéro, de telle sorte qu'aucun poil ni aucun cheveu ne pourront être coincés intérieurement.

2. Appareil électrique comprenant une batterie (B), un élément consommateur (2) électrique, alimenté par la batterie, par l'intermédiaire d'un interrupteur (21) électronique, l'amenée de puissance à cet élément consommateur (2), lors d'une décharge déterminée de la batterie, devenant réduite, jusqu'à ce que la puissance amenée devienne égale à zéro, et un discriminateur de tension (8), qui détecte une tension (U) préallouée, à la batterie (B),
caractérisé en ce,
que l'appareil électrique est un rasoir ou une tondeuse à cheveux électriques,
que l'élément consommateur électrique est un moteur à courant continu (M),
qu'un dispositif d'affichage (9), pour l'indication de l'état de charge de la batterie (B), est présent,
que, lors d'atteintes de la tension (U) préallouée, à la batterie (B), le discriminateur de tension (8) démarre un élément temporisateur (5), lequel commande le dispositif d'affichage (9) et, après écoulement d'un temps préalloué, lorsque le dispositif d'affichage (9) indique l'état de charge "zéro", sépare le moteur à courant continu (M), au moyen de l'interrupteur (21) électronique, de la batterie (B), attendu que la vitesse de rotation du moteur sera réduite, pas-à-pas ou de façon continue, jusqu'à zéro, de telle sorte qu'aucun poil ou aucun cheveux ne pourront être coincés intérieurement.

3. Appareil électrique selon la revendication 1 ou la revendication 2,
caractérisé en ce,
que l'élément temporisateur (5), après écoulement du temps préalloué, commande un modulateur de largeur d'impulsion (4), qui réduit le rapport de durée d'application dans le temps de la tension de commande pour l'interrupteur (21) électronique, de sorte que la vitesse de rotation du moteur sera réduite, pas-à-pas ou de façon continue, jusqu'à zéro.

4. Appareil électrique selon la revendication 3,
caractérisé en ce,
que la réduction de la vitesse de rotation du moteur a lieu de façon linéaire avec le temps.

5. Appareil électrique selon la revendication 3,
caractérisé en ce,
que la réduction de la vitesse de rotation du moteur a lieu, de façon semblable à l'allure de la courbe d'une tension de batterie chutant, peu avant la décharge complète.

6. Appareil électrique selon la revendication 1 ou la revendication 2,
caractérisé en ce,
que l'élément temporisateur (5) est un compteur de temps fixe, rythmé par un oscillateur (6).

7. Appareil électrique selon la revendication 6,
caractérisé en ce,
que les unités : compteur de temps fixe (5), oscillateur (6) et modulateur de largeur d'impulsion (4), sont des parties constitutives d'un microprocesseur.

8. Appareil électrique selon la revendication 6,
caractérisé en ce,
que le compteur de temps fixe (5) est divisé en des intervalles de temps fixes, qui seront indiqués par le dispositif d'affichage (9).

9. Appareil électrique selon la revendication 2,
caractérisé en ce,
que, lors du démarrage de l'élément temporisateur (5), le dispositif d'affichage (9), lors de non-coïncidence de l'état de charge indiqué avec l'état de charge détecté de la batterie (B), sera corrigé et/ou une autre indication du dispositif d'affichage (9) sera démarrée.

10. Appareil électrique selon la revendication 9,
caractérisé en ce,
que l'autre indication du dispositif d'affichage (9) indique des minutes restant encore jusqu'à l'écoulement du temps préalloué.

11. Appareil électrique selon la revendication 2,
caractérisé en ce,
que le discriminateur de tension (8) et l'élément temporisateur (5) sont mis en circuit en parallèle, directement à la batterie, et que le circuit série de l'élément consommateur (2) électrique avec l'interrupteur (21) électronique est susceptible d'être raccordé, par l'intermédiaire d'un interrupteur (S) de mise en et hors service, à la batterie (B).
